(19) Europäisches Patentamt
European Patent Office
Office européen des brevets

(11) **EP 3 254 351 B1**

(12) **EUROPÄISCHE PATENTSCHRIFT**

(45) Veröffentlichungstag und Bekanntmachung des Hinweises auf die Patenterteilung:
**21.04.2021 Patentblatt 2021/16**

(21) Anmeldenummer: **16701757.3**

(22) Anmeldetag: **26.01.2016**

(51) Int Cl.:
*H02J 3/38* (2006.01)  *G01R 19/165* (2006.01)
*H02M 1/12* (2006.01)  *G01R 31/42* (2006.01)
*H02M 5/458* (2006.01)  *H02J 3/01* (2006.01)

(86) Internationale Anmeldenummer:
**PCT/EP2016/051570**

(87) Internationale Veröffentlichungsnummer:
**WO 2016/124448 (11.08.2016 Gazette 2016/32)**

(54) **FILTERÜBERWACHUNG**

FILTER MONITORING

CONTRÔLE DE FILTRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.02.2015 DE 102015101766**

(43) Veröffentlichungstag der Anmeldung:
**13.12.2017 Patentblatt 2017/50**

(73) Patentinhaber: **ConverterTec Deutschland GmbH 47906 Kempen (DE)**

(72) Erfinder:
• **LEITING, Dirk Volker 46519 Alpen (DE)**

• **KRETSCHMANN, Jörg 47906 Kempen (DE)**
• **VAN LEYEN, Jan 47623 Kevelar (DE)**
• **ENGELHARDT, Stephan 47665 Sonsbeck (DE)**

(74) Vertreter: **Cohausz & Florack Patent- & Rechtsanwälte Partnerschaftsgesellschaft mbB Bleichstraße 14 40211 Düsseldorf (DE)**

(56) Entgegenhaltungen:
EP-A1- 2 833 535      EP-A2- 2 814 150
WO-A2-2006/081531      JP-A- 2012 143 094
US-A1- 2001 048 604      US-A1- 2011 057 517

EP 3 254 351 B1

**Beschreibung**

Die Erfindung betrifft eine Vorrichtung zur Abgabe regenerativ erzeugter elektrischer Leistung an eine Verbraucherimpedanz, welche mindestens einen Umrichter und mindestens einen Filter aufweist, wobei die Vorrichtung zur Abgabe elektrischer Leistung dreiphasig ausgebildet ist und der mindestens eine Filter entweder in einer Sternschaltung oder einer Dreieckschaltung parallel zu den Leistungsausgängen betrieben wird. Daneben betrifft die Erfindung ein Verfahren zum Betreiben einer erfindungsgemäßen Vorrichtung zur Abgabe regenerativ erzeugter elektrischer Leistung an eine Verbraucherimpedanz, welche mindestens einen Umrichter und mindestens einen dreiphasigen Filter aufweist. Schließlich betrifft die Erfindung auch ein Computerprogrammprodukt zum Betreiben eines erfindungsgemäßen Verfahrens unter Verwendung einer erfindungsgemäßen Vorrichtung.

Vorrichtungen zur Abgabe elektrischer Leistung an eine Verbraucherimpedanz, welchen die elektrische Leistung über einen Umrichter abgeben, weisen in der Regel Filter auf, um die Leistungsabgabe des Umrichters an die Verbraucherimpedanz anzupassen. Typische Beispiele solcher Vorrichtungen sind beispielweise Photovoltaikanlagen und Windenergieanlagen, welche ihre elektrische Leistung an einen Verbraucher oder ein Verbrauchernetz abgeben. Die Filter der Vorrichtungen ermöglichen nun eine Minimierung von Leistungsverlusten des Umrichters und werden in der Regel auch zur Unterdrückung oder Reduzierung der Abgabe von Oberschwingungen an den Verbraucher eingesetzt. Die korrekte Funktionsweise der Filter ist für die Anpassung der Vorrichtung an die Verbraucherimpedanz sehr wichtig. Weicht der Filter zu stark von der festgelegten Spezifikation ab, kann es zu hohen Verlustleistungen der Vorrichtung kommen. Diese können zum vollständigen Ausfall oder auch zu einer Zerstörung der Anlage aufgrund der mangelnden Funktionsweise des Filters führen. Insbesondere Vorrichtungen mit großer Leistungsabgabe, beispielsweise Windenergieanlagen im MW-Bereich, erfordern eine optimale Anbindung an die Verbraucherimpedanzen, also beispielsweise an ein Netz, um Verlustleistungen und Ausfälle zu minimieren. Auch die Reduktion von Oberschwingungen (Harmonische), welche die Umrichter aufgrund der verwendeten Schaltfrequenzen abgeben, ist eine wichtige Funktion der verwendeten Filter. Diese Oberschwingungen können beim Verbraucher Störungen verursachen und müssen daher ausreichend über die Filter gedämpft werden. Insbesondere bei Abgabe der elektrischen Leistung an ein elektrisches Netz sind hier Anforderungen der Stromnetzbetreiber zu berücksichtigen, welche sowohl eine Impedanzanpassung als auch einen Höchstwert von harmonischen Oberschwingungen (etwa 1 kHz bis 10 kHz) vorgeben. Die korrekte Funktionsweise jedes Filters bzw. Filtergruppe ist aber für den Einsatz von Vorrichtungen zur Abgabe von elektrischer Leistung an eine Verbraucherimpedanz wichtig.

Aus dem Stand der Technik ist aus der US-Patentschrift US 8,898,025 B2 bekannt, die Funktionsweise der vorhandenen Filter durch einen Vergleich von berechneter und vorbestimmter Blindleistung während des Übergangs vom Vorladen zum Normalbetrieb der Windenergieanlage zu bestimmen. Hierbei werden Messsensoren verwendet, welche zur Messung der Ausgangsleistung dienen. Zwar erlaubt das aus dem Stand der Technik bekannte Verfahren eine Überprüfung der Funktionsweise der Filter bzw. Netzfilter einer Windenergieanlage, allerdings sind die verwendeten Messwandler für die relativ hohen Ausgangsleistungen der Windenergieanlage ausgelegt. Die Ausgangsströme sind aber um einen Faktor von 10 bis 100 größer als Ströme die in den Filtern bzw. Netzfiltern auftreten. Das bekannte Verfahren erlaubt daher nur eine sehr ungenaue Bestimmung der Funktionsweise der Filter. Die Messung erlaubt daher keine genauen Rückschlüsse auf spezifische Probleme einzelner Baugruppen, beispielsweise durch Alterung oder Verwendung falscher Bauteile bei der Montage. Zudem kann die Überprüfung der Filter nur beim Startvorgang der Anlage erfolgen, so dass ein Defekt der Filter erst mit dem nächsten Startvorgang ermittelt werden könnte. Es besteht also die Gefahr, dass Schäden an der Windenergieanlage aufgrund eines defekten Filters entstehen oder Betriebszeiten durch ungeplante Reparaturzeiten verringert werden. Problematisch ist dies insbesondere bei schwer zugänglichen Vorrichtungen, beispielsweise Offshore-Windenergieanlagen.

Aus dem Stand der Technik der europäischen Patentanmeldung EP 2 833 535 A1 ist eine Vorrichtung zur Abgabe elektrischer Energie mit Umrichtern und Filtereinheiten sowie einer Kontrolleinheit bekannt.

Die US-Patentanmeldung US 2011/0057517 A1 betrifft eine Vorrichtung zur Erzeugung elektrischer Energie, welche eine aktive Filtereinheit und eine passive Filtereinheit umfasst.

Aus der Druckschrift der europäischen Patentanmeldung EP 2 814 150 A2 ist eine entsprechende Vorrichtung mit einem Umrichter bekannt, welche mindestens einen Filter umfasst und die verwendeten Filterschaltkreise in Bezug auf Schäden oder Degradation überwacht.

Aus der US 2001/0048604 A1 und der JP 2012 143094 A sind Vorrichtungen mit Umrichtern bekannt, bei welchen Filterströme gemessen werden und zur Berechnung von Ansteuersignalen der PWM-Steuerung des Umrichters verwendet werden. Weder die Abgabe regenerativ erzeugter elektrischer Energie an eine Verbraucherimpedanz noch eine Überwachung der Funktion der Filter steht im Vordergrund der Dokumente.

Aus der europäischen Patentanmeldung EP 0 645 866 A1 ist schließlich ein Verfahren zur Überwachung des Phasenwinkels zwischen Filterstrom und Filterspannung für jede Phase eines Filters bekannt, um eine optimale Funktion des Filters im Bereich der Sollfrequenz zu überprüfen. Die Überwachung der Filterströme bezüglich vorgegebener Sollwerte der Filterströme ist aus dieser europäischen Patentanmeldung nicht bekannt.

Aufgabe der vorliegenden Erfindung ist es daher, eine Vorrichtung zur Abgabe regenerativ erzeugter elektrischer Leistung sowie ein entsprechendes Verfahren zum Betreiben einer Vorrichtung zur Abgabe regenerativ erzeugter elektrischer Leistung zur Verfügung zu stellen, welche bzw. welches eine verbesserte Überwachung der Funktionsweise der Filter bzw. Netzfilter bei geringem Aufwand zulässt. Die Aufgabe wird mit einer Vorrichtung gemäß Patentanspruch 1 sowie einem Verfahren nach Patentanspruch 8 gelöst.

Erfindungsgemäß sind in der Vorrichtung Mittel zur Bestimmung von mindestens einem Filterstrom in mindestens einem dreiphasigen Filter vorgesehen, welche derart ausgebildet sind, dass diese eine Bestimmung des mindestens einen Filterstroms während des Betriebs der Vorrichtung ermöglichen.

Anders als im Stand der Technik werden explizit Mittel zur Bestimmung mindestens eines Filterstroms verwendet. Hierdurch ist es möglich, nicht nur während des Startvorgangs sondern immer dann, wenn die Filter an Spannung liegen, also beispielsweise während des Vorladens, im Stillstand oder auch im Normalbetrieb mit Leistungsabgabe, die Filter zu überwachen. Anhand der bestimmten Filterstromwerte kann während des Betriebs der Anlage eine ständige Kontrolle der Filter in Bezug auf deren Funktionsweise erfolgen. Im Gegensatz zu dem aus dem Stand der Technik bekannten Verfahren und der bekannten Vorrichtung können die Mittel zur Bestimmung der Filterströme auf die Größenordnung der Filterströme ohne Probleme abgestellt werden, so dass eine höhere Genauigkeit bei der Ermittlung der Filterströme erzielt wird. Im Ergebnis kann mit der erfindungsgemäßen Vorrichtung die Funktionsweise der Filter kontinuierlich oder zu bestimmten Zeiten überwacht werden. Die genauere Filterstrombestimmung ermöglicht zudem frühzeitige Aussagen in Bezug auf Alterungsprozesses oder Abweichungen der Netzfilter von deren vordefinierten Spezifikation. Eine Reparatur oder ein Austausch kann daher beispielsweise bereits geplant werden, bevor es zum Ausfall der Vorrichtung kommt. Beispielsweise ermöglicht eine kontinuierliche Überwachung der Filterströme auch, dass bei regelmäßigen Wartungen der Vorrichtung von der Spezifikation abweichende Bauteile ausgetauscht werden können, sobald die ermittelten Filterströme Anlass hierzu geben. Einem plötzlichen Ausfall kann so entgegengewirkt werden.

Erfindungsgemäß weisen die Mittel zur Bestimmung des mindestens einen Filterstroms mindestens einen Stromsensor zur Messung des Stroms in mindestens einer Phase des mindestens einen dreiphasigen Filters auf. Erfindungsgemäße Vorrichtungen zur Abgabe elektrischer Leistung an ein Verbrauchernetz sind dreiphasig ausgebildet. Die Filter werden entweder in einer Sternschaltung oder einer Dreieckschaltung parallel zu den Leistungsausgängen der Vorrichtung betrieben. Wird beispielsweise in lediglich einer Phase des mindestens einen Filters eine Strommessung unter Verwendung eines Stromsensors durchgeführt, kann mit minimalem Aufwand bei einer Sternschaltung des Filters nahezu alle möglichen Fehlerquellen, insbesondere das Abweichen von den Nennwerten der Komponenten detektiert werden. Werden die Filterströme von zwei Phasen eines Netzfilters z.B. durch Differenzmessung mittels eines Stromwandlers gemessen, kann auch ein Filter in Dreieckschaltungstopologie in Bezug auf die Funktion aller Komponenten überwacht werden. Gleiches gilt selbstverständlich auch bei einer nicht erfindungsgemäßen Messung aller drei Filterstromphasen.

Alternativ ist mindestens ein Stromsensor vorgesehen, welcher zur Messung der Differenzströme zweier Phasen mindestens eines Filters ausgebildet ist, kann mit minimalem Aufwand eine Filterüberwachung sowohl bei einer Sternschaltung als auch bei einer Dreieckschaltung, also unabhängig von der Topologie des jeweiligen Filters erfolgen und gleichzeitig alle möglichen Fehlermöglichkeiten ermittelt werden.

Bevorzugt werden bei der Filterstrommessung induktive Stromwandler, beispielsweise mit Eisenkern, Rogowski-Stromwandler oder Stromwandler mit Hall-Sensoren verwendet, die dem Fachmann hinlänglich bekannt sind. Diese Sensoren zeichnen sich durch einen geringen Aufwand und eine ausreichende Genauigkeit aus. Denkbar sind aber auch andere Ausführungen von Stromsensoren, z.B. Shunts.

Gemäß einer weiteren Ausgestaltung der Vorrichtung ist mindestens eine Filtergruppe vorgesehen, wobei die Mittel zur Bestimmung der Filterströme zumindest teilweise eine Bestimmung der Filterströme der einzelnen Filtergruppen ermöglichen, so dass die Funktionsweise einzelner Filtergruppen überwacht werden kann. Eine Filtergruppe umfasst per Definition mehrere Filter. Filtergruppen werden beispielsweise dann verwendet, wenn einzelne Filter auf spezifische Frequenzen, z.B. die Schaltfrequenz oder deren Harmonische, abgestimmt sind. Ein weiterer Grund kann darin liegen, dass die Leistungsabgabe der Vorrichtung groß ist, beispielsweise mindestens 1,5 MW oder um einen kostengünstigen Filteraufbau durch Verwendung von verfügbaren Komponenten und Bauteilen zu gewährleisten. Eine Mehrzahl an Filtergruppen wird auch bei Leistungsabgaben von mindestens 1,5 MW verwendet, um kostengünstigere Bauelemente zu verwenden. Auch diese Filtergruppen können mit der erfindungsgemäßen Vorrichtung einzeln überwacht werden.

Weist die erfindungsgemäße Vorrichtung gemäß einer weiteren Ausgestaltung einen Netzanschluss auf und ist mindestens ein Netzfilter vorgesehen, kann ein sicherer Betrieb der Vorrichtung an einem elektrischen Netz sichergestellt werden. Die Netzfilterüberwachung während des Betriebes gewährleistet, dass bei Abweichungen aus dem Normalbetrieb vorab eingegriffen werden kann. Insbesondere bei Vorrichtung mit einer Leistung oberhalb von 1,5 MW können Ausfallzeiten durch gezielte Wartungsmaßnahmen, beispielsweise durch frühzeitigen Austausch eines Kondensators eines Filters, reduziert werden und die Wirtschaftlichkeit der Vorrichtung gesteigert werden.

Gemäß einer nächsten Ausgestaltung ist die Vorrichtung zur Abgabe elektrischer Leistung eine Windenergieanlage mit einer doppeltgespeisten Asynchronmaschine oder eine Windenergieanlage mit einer Synchronmaschine.

Bei Verwendung einer doppeltgespeisten Asynchronmaschine wird nur ein Teil der erzeugten elektrischen Leistung über den Umrichter geführt, während bei Verwendung einer Synchronmaschine die komplette Leistung über den Umrichter geführt wird. Dabei spielt es keine Rolle, um welche Art Synchronmaschine es sich handelt, beispielsweise elektrisch erregt oder durch Permanentmagnete erregt. Die korrekte Funktionsweise der Netzfilter stellt durch die Netzfilterüberwachung eine hohe Verfügbarkeit der Windenergieanlagen am Netz sicher und beugt möglichen Schäden an der Windenergieanlage durch Ausfall eines Filters vor. Bei Windenergieanlagen mit einer doppeltgespeisten Asynchronmaschine können auch bei dem Einsatz verschieden angeordneter Filtergruppen, welche beispielsweise zwischen Stator und Netz, zwischen netzseitigem Umrichter und Netz oder zwischen dem Verknüpfungspunkt von Stator und netzseitigem Umrichter und dem Netz vorgesehen sind, diese auch einzeln überwacht werden, um so einen optimalen Betrieb der Vorrichtung zu ermöglichen. Denkbar ist der Einsatz der erfindungsgemäßen Vorrichtung allerdings auch bei anderen regenerativ erzeugte elektrische Leistung in ein Netz abgebenden Vorrichtungen mit einem Umrichter, beispielsweise Photovoltaikanlagen oder Wasserkraftwerke.

Bevorzugt ist der mindestens eine Filter als Saugkreis, Hochpass-, Tiefpass-, RC-Filter oder als Filter höherer Ordnung ausgebildet. Durch die Überwachung der verschiedenen Filtertypen kann die Überwachung des Betriebs der Vorrichtung zur Abgabe elektrischer Energie, beispielsweise zur Abgabe elektrischer Energie an ein Netz insbesondere auch auf die Einhaltung der Netzanschlussparameter hin weiter verbessert werden. Beispielsweise kann bei einem festgestellten Ausfall eines Filters die Vorrichtung mit einer geänderten Schaltfrequenz betrieben werden, um den Ausfall des Filters zu kompensieren und die Netzanschlussbedingungen weiterhin einzuhalten.

Erfindungsgemäß sind Vergleichsmittel vorgesehen, welche unter Verwendung des Soll- und Istwertes des Filterstroms sowie eines vorgebbaren Fehlerkriteriums ein Fehlerinformationssignal (S) erzeugen. Der Sollwert wird unter Verwendung der Spannungswerte der drei Phasen des Filters ermittelt. Unter Berücksichtigung der Messung der Ströme einer Phase, zweier Phasen oder aller drei Phasen des Filters kann dann ein Istwert berechnet werden. Anhand der bekannten Nennwerte der Bauelemente des jeweiligen Filters, welche beispielsweise als Parameter vorgegeben werden können, oder anhand einer initialen Messung der aktuellen Kennwerte des Filters können basierend auf der Kenntnis der anliegenden Spannungswerte zu jeder Phase des Filters Referenzwerte für die Filterströme zu jedem Zeitpunkt berechnet werden. Diese werden der Einfachheit halber als αβ- oder αβ0-Komponenten berechnet.

Bei Messung aller drei Phasen L1, L2 und L3 der Filterströme können gemäß folgender Gleichung die αβ0-Komponenten berechnet:

$$\begin{bmatrix} i(t)_{F,\alpha} \\ i(t)_{F,\beta} \\ i(t)_{F,0} \end{bmatrix} = \frac{1}{3} \cdot \begin{bmatrix} 2 & -1 & -1 \\ 0 & \sqrt{3} & -\sqrt{3} \\ 1 & 1 & 1 \end{bmatrix} \cdot \begin{bmatrix} i(t)_{F,L1} \\ i(t)_{F,L2} \\ i(t)_{F,L3} \end{bmatrix} \tag{1}$$

und ein direkter Vergleich der Soll- und Ist-Werte der αβ0-Komponenten der Filterströme durchgeführt werden.

Bei Messung von nur zwei Phasen L1 und L2 der Filterströmen ergeben sich unter der Annahme dass keine 0-Komponente vorhanden ist die αβ-Komponenten der Filterströme aus folgender Gleichung:

$$\begin{bmatrix} i(t)_{F,\alpha} \\ i(t)_{F,\beta} \end{bmatrix} = \begin{bmatrix} 1 & 0 \\ \frac{1}{\sqrt{3}} & \frac{2}{\sqrt{3}} \end{bmatrix} \cdot \begin{bmatrix} i(t)_{F,L1} \\ i(t)_{F,L2} \end{bmatrix} \tag{2}$$

Die αβ -Komponenten spannen ein orthogonales Koordinatensystem auf, von dem der zeitabhängige komplexe Raumzeiger $\underline{u}_F$ abgeleitet werden kann. Berücksichtigt man jetzt lediglich die Impedanz für eine bestimmte Frequenz, beispielsweise die Grundschwingung können Referenzwerte für die Filterstromkomponente in dem αβ - Koordinatensystem ermittelt werden.

Aber auch wenn lediglich nur eine Phase der Filterströme gemessen wird, kann ein entsprechendes Fehlerkriterium ermittelt werden. Bei bekannter Impedanz kann durch die gemessenen Spannungswerte $\underline{u}_F$ auch abhängig von der jeweiligen gemessenen Stromphase ein Referenzwert, beispielsweise $i_{F,ref,L1}$ ermittelt werden und mit dem tatsächlich gemessenen Wert für den Filterstrom beispielsweise in der Phase L1 $i_{F,L1}$ verglichen werden. Bevorzugt kann beispielsweise ein zeitlicher Mittelwert der Differenz des Referenzfilterstroms der Phase L1 und des gemessenen Filterstroms der Phase L1 gebildet werden.

Der Vergleich des Referenzwertes (Sollwert) für den Strom einer Filterphase $i_{F,ref,L1}$ mit dem tatsächlichen gemessenen Wert des Filterstroms bzw. der Mittelwert der Differenz beider Werte wird bevorzugt im mit Netzfrequenz drehenden αβ - Koordinatensystem durchgeführt. Dies kann bei rein kapazitiven Filtern oder induktiven Filtern dazu genutzt werden, den Vergleich zwischen Referenzwert und tatsächlichem Wert des Filterstroms nur in einer Komponente

des $\alpha\beta$ - Koordinatensystem, beispielsweise der $\alpha$-Komponente bei rein kapazitiven Filtern, durchzuführen. Dies führt zu einer weiteren Vereinfachung der Vorrichtung und des anzuwendenden Verfahrens.

Als Fehlerkriterium kann beispielsweise ein relativer Wert der Abweichung des gemessenen Stroms von dem Referenzstrom in p.u. angegeben werden. Beispielsweise kann das Fehlerkriterium dann erfüllt sein, wenn die Differenz zwischen Referenzstrom und ermitteltem Istwert des Filterstroms mehr als 10 bis 15 % des Referenzstromes beträgt. Ist das Fehlerkriterium erfüllt, wird ein entsprechendes Fehlerinformationssignal erzeugt. Es ist denkbar, verschiedene Fehlerkriterien zu formulieren, um beispielsweise die Alterung der Bauteile, die bestimmungsgemäße Funktion der Bauteile oder den Einsatz falscher Bauteile erkennen zu können. Die Fehlerkriterien können dann von einer Regelung ausgewertet werden um entsprechende Aktionen einzuleiten.

Es gibt selbstverständlich auch andere Wege ein Fehlerinformationssignal bei einphasiger Strommessung zu bestimmen. Beispielsweise kann dies durch einen direkten Vergleich der $\alpha$- und $\beta$-Komponenten des Referenzstroms und des gemessenen Stroms beispielsweise der Phase L1 des Filters durchgeführt werden. Hierzu können Messgrößen, beispielsweise ein Produkt der $\alpha\beta$-Komponenten der Spannung $\underline{u}_F$ und der $\alpha\beta$-Komponenten des gemessenen Filterstroms $\underline{i}_F$ gebildet und ausgewertet werden. Von hochfrequenten Schwingungsanteilen durch Filtern befreit, kann über das Produkt ein direkter Wert für die Differenz zwischen Referenzfilterstrom und gemessenem Filterstrom angegeben werden.

Schließlich kann die Vorrichtung gemäß einer weiteren Ausgestaltung dadurch vorteilhaft ausgestaltet werden, dass Mittel zur Betriebsänderung der Vorrichtung, Mittel zur Abschaltung mindestens eines Filters oder einer Filtergruppe oder Mittel zur Änderung der Schaltfrequenz abhängig vom Fehlerinformationssignal vorgesehen sind. Es besteht dann die Möglichkeit, die Vorrichtung beispielsweise auch bei einem Defekt eines Filters in einem sicheren Zustand weiter zu betreiben, bis eine Reparatur möglich ist. Dadurch kann eine im Vergleich zu einer Abschaltung der Anlage erhöhte Leistung in das Netz eingespeist werden, wodurch die Versorgungssicherheit sowie der Energieertrag der Anlage gesteigert werden können. Die Mittel zur Abschaltung mindestens eines Filters können beispielsweise Schütze sein, mittels derer die Filter vom übrigen Dreiphasensystem getrennt werden können.

Gemäß einer zweiten Lehre der vorliegenden Erfindung wird die aufgezeigte Aufgabe durch ein Verfahren zum Betreiben einer Vorrichtung zur Abgabe regenerativ erzeugter elektrischer Leistung dadurch gelöst, dass während des Betriebs der Vorrichtung zur Abgabe elektrischer Leistung mindestens ein Filterstrom in dem mindestens einen Filter ermittelt und der mindestens eine Filter abhängig vom ermittelten Filterstrom überwacht wird.

Wie bereits zuvor ausgeführt, zeichnet sich die vorliegenden Erfindung dadurch aus, dass anders als im bisher bekannten Stand der Technik, eine im Betrieb stattfindende Überwachung der Filter auf Funktion erfolgt, so dass auch schleichende Veränderungen, beispielsweise Alterung von Bauelementen über die Filterstrommessung erfasst werden können. Überwachung des Filters bedeutet hier eine kontinuierliche oder diskontinuierliche Ermittlung der Filterströme am Filter. Hierdurch besteht die Möglichkeit, Komponenten der Filter bereits vor deren Ausfall auszutauschen. Prinzipiell kann eine Filterstromüberwachung auch den Einsatz von Sicherungsüberwachungen ersetzen. Hierbei handelt es sich um zusätzliche Hardware, welche auf die Sicherung montiert wird und ein elektrisches Signal liefert, sobald die Sicherung ausgelöst hat. Mit Hilfe der Filterstromüberwachung ist es aber möglich, das Ansprechen einer Sicherung über den veränderten Stromfluss im Filter zu detektieren und somit ein entsprechendes Fehlerinformationssignal zu erzeugen. Dadurch kann sowohl die Hardware als auch der Verdrahtungsaufwand für die Sicherungsüberwachung eingespart werden. Weiterhin ist es denkbar, komplett auf die Filtersicherungen zu verzichten, wenn Mittel zur Abschaltung der Filter vorhanden sind, welche aufgrund eines Fehlerinformationssignals der Filterstromüberwachung angesteuert werden können und somit eine schnelle Trennung der defekten Filter ermöglichen.

Vorzugsweise werden gemäß einer ersten Ausgestaltung des Verfahrens unter Verwendung mindestens eines Stromsensors der Filterstrom in mindestens einer Phase des mindestens einen Filters oder ein Differenzstrom zweier Phasen des mindestens einen Filters gemessen. Diese direkte Messung des Filterstroms kann beispielsweise über induktive Stromwandler, Rogowski-Stromwandler oder über Stromwandler mit Hall-Sensoren erfolgen. Zudem kann eine Differenzstrommessung einfach durch einen gegenläufigen Verlauf der beiden Phasen im Stromwandler erreicht werden.

Bevorzugt erzeugen gemäß einer zweiten Ausgestaltung des Verfahrens Vergleichsmittel unter Verwendung des mindestens einen Filterstroms mindestens einer Phase mindestens eines Filters oder mindestens eines Differenzfilterstroms zweier Phasen mindestens eines Filters und der gemessenen Spannungswerte an dem mindestens einen Filter sowie eines vorgebbaren Fehlerkriteriums ein Fehlerinformationssignal. Bei dem Fehlerkriterium kann es sich, wie bereits dargestellt, im einfachsten Fall lediglich um die Abweichung des ermittelten Filterstroms von einem Referenzstrom vorzugsweise im $\alpha\beta$-System handeln. Allerdings besteht auch die Möglichkeit zeitliche Mittelwerte oder grundschwingungsfreie Komponenten unter Verwendung des ermittelten Filterstroms zu berechnen. Hierdurch kann eine Stellgröße ermittelt werden, welche direkt proportional zur Abweichung des Filterstroms vom Referenzfilterstrom ist.

Die Überwachung von mehrstufig, beispielsweise in Filtergruppen aufgeteilte Filter kann gemäß einer weiteren Ausgestaltung des Verfahrens auf einfache Weise dadurch erfolgen, dass der Filterstrom in mindestens einer Phase oder der Differenzstrom zweier Phasen einer Mehrzahl an Filtergruppen gemessen wird und zumindest teilweise die einzelnen Filtergruppen abhängig von den ermittelten Filterströmen oder Differenzfilterströmen überwacht werden. Es ist dann möglich, einzelne Filtergruppen als fehlerhaft zu identifizieren, um beispielsweise ein Abschalten der Filtergruppe durchzuführen.

Gemäß einer weiteren Ausführungsform des Verfahrens ist es vorteilhaft, das Fehlerinformationssignal aus einem Vergleich zwischen Soll- und Istwert mindestens eines Filterstroms, beispielsweise den αβ-Komponenten oder aus einem Vergleich des Soll- und Istwerts mindestens einer unter Verwendung des ermittelten Filterstroms berechneten Größe sowie mindestens eines vorgebbaren Fehlerkriteriums zu berechnen. Beispielsweise steht hierfür ein zeitlicher Mittelwert der Differenz zwischen Soll- und Istwert der gemessenen Filterstromphase zur Verfügung. Andererseits kann als berechnete Größe beispielsweise auch das Produkt der αβ-Komponenten der Filterspannung und des gemessenen Filterstroms herangezogen werden und mit dem Produkt des Referenzstroms verglichen werden.

Vorzugsweise wird das mindestens eine vorgebbare Fehlerkriterium in Abhängigkeit der zu überwachenden Eigenschaft des mindestens einen Filters gewählt. Die zu überwachende Eigenschaft des Filters kann beispielsweise der Aufbau, die Alterung der Bauteile oder ein Defekt sein. Eine Überwachung in Bezug auf den Aufbau des mindestens einen Filters und somit auf die Verwendung der richtigen Bauteile bei der Montage kann beispielsweise durch Vergleich des Filterkriteriums bei der Endprüfung der Vorrichtung zur Abgabe elektrischer Leistung beim Hersteller erfolgen. Weichen die Filterströme zu stark von den berechneten Werten ab, kann auf einen fehlerhaften Aufbau des Filters geschlossen werden. Alterung des Filters kündigt sich in der Regel durch Änderung der Kennwerte der verwendeten Bauteile an, so dass auch hier eine Differenz zwischen Referenzströmen und gemessenen Filterströmen messbar wird, welche möglicherweise anwächst. Selbstverständlich kann auch ein Defekt einer Komponente eines Filters durch die Filterstrommessung ermittelt werden.

Besonders bevorzugt wird die Ermittlung des mindestens einen Filterstroms oder des mindestens einen Differenzfilterstroms für vordefinierte Frequenzen, insbesondere für die Grundschwingung oder eine Harmonische durchgeführt. Insbesondere das Verhalten des Umrichters für die Grundschwingung ist wichtig für die Leistungsabgabe an einen Verbraucher und somit an einen effizienten Betrieb der Vorrichtung. Die Messung der Filterströme im Bereich der harmonischen Frequenzen ermöglicht eine Überprüfung des Dämpfungsverhaltens des Filters bezüglich der Einkopplung der Harmonischen der Schaltfrequenzen des Umrichters in das Verbrauchernetz. Denkbar sind selbstverständlich auch andere Frequenzen, beispielsweise Oberschwingungen der Schaltfrequenz, allerdings sind die Grundschwingung und die erste Harmonische die wesentlichen Frequenzen, in welchen Filterströme relevant sind.

Zudem kann gemäß einer weiteren Ausgestaltung des erfindungsgemäßen Verfahrens abhängig von dem Fehlerinformationssignal der Betrieb der Vorrichtung geändert werden, mindestens ein Filter abgeschaltet und/oder die Schaltfrequenz des Umrichters geändert wird. Eine Änderung des Betriebs der Vorrichtung beispielsweise bei Vorliegen eines Filterdefekts kann in der Anpassung der abgegebenen Leistung münden. Dies macht beispielsweise dann Sinn, wenn zwei baugleiche Filter für die gleiche Frequenz vorgesehen sind, um somit die Filterleistung zu erhöhen. Ist einer dieser Filter defekt, muss die abgegebene Leistung der Anlage angepasst werden, um den verbleibenden funktionsfähigen Filter nicht zu überlasten. Darüber hinaus ist es auch vorteilhaft bei Auftreten eines Fehlers lediglich den entsprechenden Filter oder die entsprechende Filtergruppe abzuschalten, um ebenfalls eine Überlastung des Filters beispielsweise in Folge eines defekten Bauteils zu vermeiden. Gleichzeitig kann es auch notwendig sein, bei einem Filterdefekt neben der Anpassung der abgegebenen Leistung die Schaltfrequenz des Umrichters zu ändern, um die vorgegebenen Netzanschlussbedingungen weiterhin einzuhalten. Sind etwa zwei Filter für die einfache und die doppelte Schaltfrequenz vorgesehen und der Filter für die einfache Schaltfrequenz ist defekt, würden die schaltfrequenten Oberschwingungen ungehindert in das Netz abgegeben. Erfolgt nun eine Anhebung auf die doppelte Schaltfrequenz, so können diese Oberschwingungen durch den noch funktionsfähigen Filter gedämpft werden.

Schließlich wird die oben aufgezeigte Aufgabe durch ein Computerprogrammprodukt gelöst, dessen Ausführung die Durchführung eines erfindungsgemäßen Verfahrens zum Betreiben einer Vorrichtung zur Abgabe elektrischer Leistung ermöglicht und die Überwachung des mindestens einen Filters durch Auswertung des Fehlerinformationssignals des mindestens eines Filters erfolgt. Wie bereits zuvor ausgeführt, kann durch das Computerprogrammprodukt eine Vorrichtung zur Abgabe elektrischer Leistung in Bezug auf den Ausfall einzelner Netzfilter oder Netzfiltergruppen mit höherer Sicherheit betrieben werden. Die aktive Überwachung der Filter entsprechender Vorrichtungen führt zu einer weiteren Optimierung der Leistungsabgabe, der Laufzeiten und der Betriebssicherheit der Vorrichtungen. Bevorzugt wird über die Auswertung des Fehlerinformationssignals eine Diagnose des Fehlers in Bezug auf die Verwendung falscher Komponenten beim Einbau, Alterung der Bauteile oder Defekt der Filter durchgeführt und optional auf einem User-Interface angezeigt.

Im Weiteren soll die Erfindung anhand von Ausführungsbeispielen in Verbindung mit der Zeichnung näher erläutert werden. Die Zeichnung zeigt in

Fig. 1        ein Ausführungsbeispiel einer Vorrichtung zur Abgabe elektrischer Leistung mit einer doppeltgespeisten Asynchronmaschine in einer schematischen Schaltskizze,

Fig. 2          ein weiteres Ausführungsbeispiel einer Vorrichtung zur Abgabe elektrischer Leistung mit einer Synchronmaschine,

Fig. 3 bis 5    Schaltskizzen von Ausführungsbeispielen unterschiedlicher Filtertopologien,

Fig. 6          ein Ablaufdiagramm für Ausführungsbeispiele des erfindungsgemäßen Verfahrens zur Filterüberwachung,

Fig. 7          ein Ausführungsbeispiel mit einem Stromwandler zur Bestimmung einer Filterstromphase eines Filters in Sternschaltung,

Fig.8           eine Schaltskizze eines Ausführungsbeispiels mit einem Stromsensor zur Messung der Differenzströme von zwei Phasen eines Filters in Dreieckschaltung,

Fig. 9          ein schematisches Ablaufdiagramm eines Ausführungsbeispiels des erfindungsgemäßen Verfahrens bei Messung nur einer Filterstromphase,

Fig. 10         ein Raumzeigerdiagramm im aß-Koordinatensystem und

Fig. 11         ein schematisches Ablaufdiagramm eines weiteren Ausführungsbeispiels des erfindungsgemäßen Verfahrens.

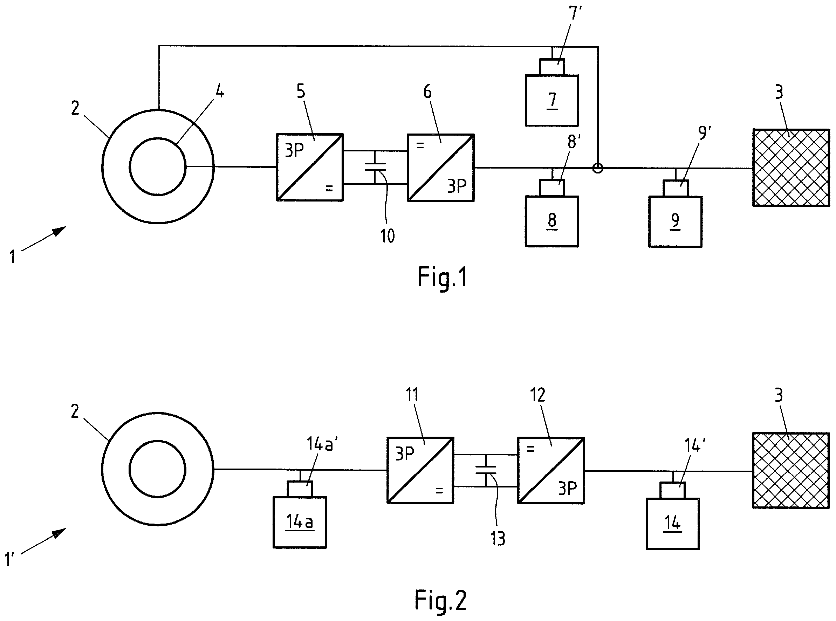

Fig. 1 und 2 zeigen zwei Ausführungsbeispiele von Vorrichtungen zur Abgabe elektrischer Leistung, wie sie üblicherweise bei Windenergieanlagen verwendet werden. Die Vorrichtung in Fig. 1 umfasst einen Generator 1, dessen Stator 2 unmittelbar mit einem elektrischen Netz 3, welches beispielsweise die Verbraucherimpedanz darstellt, verbunden ist. Der Rotor 4 des Generators 1 ist über einen maschinenseitigen Umrichter 5, einen Gleichspannungszwischenkreis 10 und einen netzseitigen Umrichter 6 an das elektrische Netz 3 angeschlossen. Der Generator ist als Asynchronmaschine ausgebildet und stellt eine doppeltgespeiste Asynchronmaschine dar, wie sie häufig für Windenergieanlagen verwendet wird. Die beiden Umrichter 5 und 6 können mit unterschiedlichen Schaltfrequenzen betrieben werden, weshalb es vorteilhaft sein kann, separate Filter 7 und 8 zu verwenden. Möglich ist es aber auch, nur einen Filter bzw. eine Filtergruppe 9 zu verwenden. Die dargestellten Filter 7, 8, 9 sind somit alle als optional zu betrachten und werden in der Praxis dem Verwendungszweck nach ausgewählt.

In dem vorliegenden Ausführungsbeispiel sind diese als Filtergruppen 7, 8 und 9 dargestellt, da diese jeweils in Bezug auf die einzelnen zu dämpfenden Systeme konfiguriert sind. So muss der Statorfilter 7 die Auswirkung des Stators 2 auf das Netz 3 dämpfen. Der Filter 8 muss dagegen die Auswirkung des Umrichters 6 auf das Netz anpassen. Der Filter 9 soll wiederum das Gesamtsystem bestehend aus dem netzseitigen Umrichter und dem Stator und dessen Rückwirkung auf das Netz 3 dämpfen. In dem Ausführungsbeispiel aus Fig. 1 sind unmittelbar mehrere Filter vorhanden, diese sind jedoch je nach Anwendungsfall auszuwählen und somit als optional anzusehen. Der Generator 1 in Fig. 1 in Form einer Asynchronmaschine kann beispielsweise mit einem Rotor eines Windrades gekoppelt werden, um so die mechanische Energie des Windes in elektrische Energie umzuwandeln.

In jedem Filter 7, 8 und 9 sind in dem Ausführungsbeispiel aus Fig. 1 jeweils Mittel 7', 8' und 9' vorgesehen, mit welchen die Filterströme in den jeweiligen Filtern 7, 8 und 9 ermittelt werden können.

Fig. 2 zeigt ein Ausführungsbeispiel einer erfindungsgemäßen Vorrichtung mit einem Generator 1', dessen Stator 2 über einen maschinenseitigen Umrichter 11, einen Gleichspannungszwischenkreis 13 und einen netzseitigen Umrichter 12 an das Netz 3 angeschlossen ist. Der Generator 1'kann beispielsweise einen permanent erregten Rotor aufweisen, so dass im Gegensatz zu der Konfiguration in Fig. 1 die gesamte Leistungsabgabe über den Umrichter 12 an das Netz 3 erfolgt. Der Netzfilter 14 soll dabei die Auswirkung des Umrichters 12 auf das Netz anpassen. Der Filter 14 muss insofern auch für die Abgabe hoher Leistungen ausgebildet sein und kann beispielsweise zur Erhöhung der Filterleistung aus mehreren baugleichen Filtern für die gleiche Frequenz, hier nicht dargestellt, aufgebaut sein. Diese Filter können auch zu einzelnen Filtergruppen zusammengefasst werden. Zusätzlich kann ein Filter 14a vorgesehen sein, um die Rückwirkungen des Umrichters 11 auf den Generator 1' und umgekehrt zu dämpfen. Auch dieser Filter enthält Mittel zur Bestimmung mindestens eines Filterstroms 14a'.

Grundsätzlich kann eine Vorrichtung zur Abgabe elektrischer Leistung aber anstelle des Generators 1 oder 1' auch andere Mittel zur Bereitstellung elektrischer Energie aufweisen, beispielsweise eine Photovoltaikanlage, welche einen Gleichstrom bereitstellt, welcher über Umrichter 6, 12 in ein elektrisches Netz abgegeben wird.

Erfindungsgemäß sind in den Vorrichtungen gemäß Fig. 1 und Fig. 2 Mittel zur Bestimmung von mindestens einem Filterstrom 7', 8', 9' oder 14' vorgesehen, welche derart ausgebildet sind, dass diese eine Bestimmung des mindestens einen Filterstroms des mindestens einen Filters 7, 8, 9 oder 14 während des Betriebs der Vorrichtung ermöglichen. In mindestens einem der verwendeten Filter 7, 8, 9 oder 14 können bevorzugt Mittel zur direkten Messung von Filterströmen vorgesehen sein. Die ermittelten oder direkt gemessenen Filterströme dienen zur Überwachung der einzelnen Filter und gewährleisten, dass die korrekte Funktion der Filter im Betrieb der Vorrichtung bekannt ist. Mit den in Fig. 1 und Fig. 2 dargestellten Vorrichtungen zur Abgabe elektrischer Leistung ist es damit möglich, anhand der Filterstrombestimmung während des Betriebs die Funktionsweise der Filter zu überwachen und bei Alterung, fehlerhaftem Aufbau oder Defekt unmittelbar eingreifen zu können.

Die Mittel 7', 8', 9', 14' oder 14a' weisen optional Mittel zum Abschalten des Filters bzw. Trennen des Filters auf, um diesen beispielsweise im Falle eines Defekts von der Vorrichtung trennen zu können.

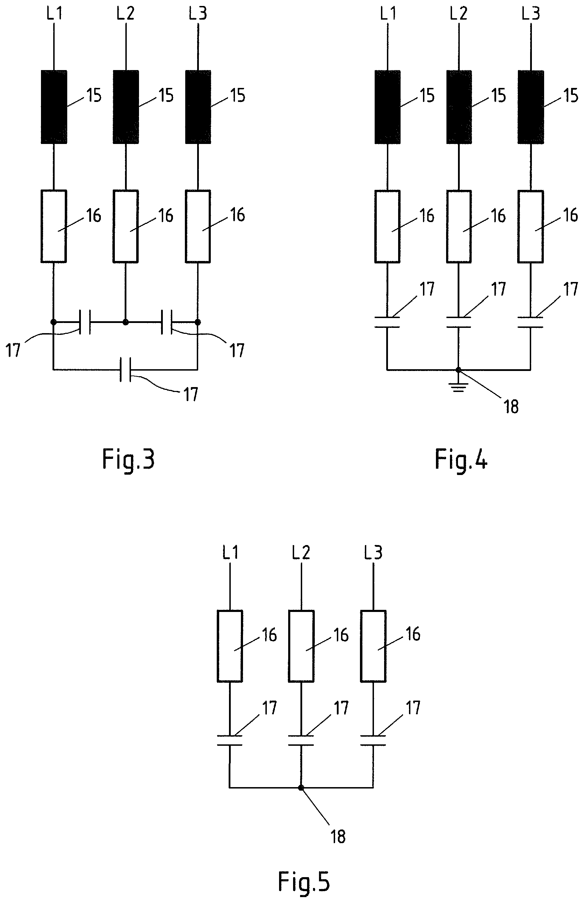

Den spezifischen Aufbau von typischerweise eingesetzten Filtertopologien zeigen die Schaltskizzen in Fig. 3, Fig. 4 und Fig. 5. In Fig. 3 ist ein sogenannter Saugkreis in Dreiecksschaltung dargestellt. Die drei Filterphasen L1, L2, L3 enthalten jeweils eine Induktivität 15, einen Widerstand 16 sowie eine Kapazität 17. Die Verbindung der drei Phasen L1, L2 und L3 des Saugkreises aus Fig. 3 erfolgt jeweils über eine Kapazität 17, so dass eine Dreieckschaltung entsteht. Bei dem als Saugkreis in Sternschaltung dargestellten Ausführungsbeispiels eines Filters in Fig. 4 werden die drei Filterphasen L1, L2, L3 an einem zentralen Punkt 18 miteinander verbunden. Der Sternpunkt 18 kann auch auf Nullpotential liegen. Die einzelnen Phasen enthalten wiederum eine Induktivität 15, einen Widerstand 16 und eine Kapazität 17.

Fig. 5 zeigt in sternförmiger Schaltung einen RC-Filter, welcher lediglich aus einem Widerstand 16 und einer Kapazität 17 pro Phase gebildet wird. Auch hier sind die Filterphasen L1, L2 und L3 am Sternpunkt 18 zusammengeführt.

Die in den Fig. 3 bis Fig. 5 dargestellten Filtertopologien stellen jedoch nur einen kleinen Ausschnitt aus den möglichen Filtertypen dar. So können die Filter als Hochpass-, Tiefpass-, Saugkreise oder RC-Filter oder aber auch als Filter höherer Ordnung ausgelegt werden. Unabhängig von deren Auslegung weisen alle Filter jedoch Anschlüsse für alle drei Phasen L1, L2 und L3 auf, welche zur Messung von Filterströmen geeignet sind. Darüber hinaus sind üblicherweise alle Filter symmetrisch in Bezug auf die einzelnen Phasen L1, L2 und L3 ausgelegt.

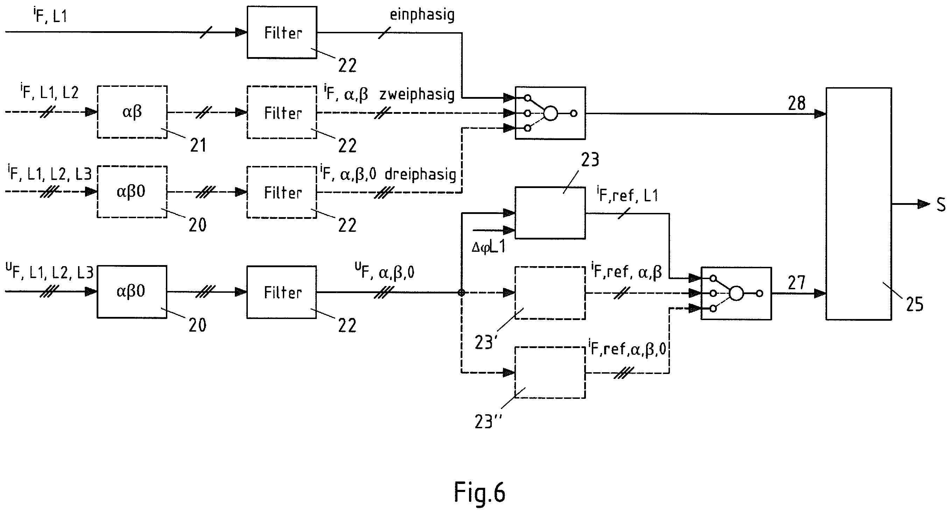

Fig. 6 ist nun ein Ablaufdiagramm für Ausführungsbeispiele des erfindungsgemäßen Verfahrens bei einphasiger, zweiphasiger oder dreiphasiger Strommessung dargestellt.

Bei dem Ausführungsbeispiel mit einphasiger Strommessung wird mindestens ein Filterstrom bestimmt, beispielsweise der Filterstrom $i_{F,L1}$ der Phase L1. Die Spannungswerte am Filter $u_F$ der Phasen L1, L2 und L3 stehen zur Verfügung, da wie aus den Fig. 1 und Fig. 2 erkennbar ist, diese der Netzspannung entsprechen und eine Messung dieser Spannung ohnehin für die Regelung des Umrichters benötigt wird.

Aus den Spannungswerten für die Phasen L1, L2 und L3 werden in Schritt 20 über eine $\alpha\beta0$-Transformation die Komponenten in dem $\alpha\beta0$-System der Spannung ermittelt. Hierzu wird folgende Gleichung verwendet:

$$\begin{bmatrix} u(t)_{F,\alpha} \\ u(t)_{F,\beta} \\ u(t)_{F,0} \end{bmatrix} = \frac{1}{3} \cdot \begin{bmatrix} 2 & -1 & -1 \\ 0 & \sqrt{3} & -\sqrt{3} \\ 1 & 1 & 1 \end{bmatrix} \cdot \begin{bmatrix} u(t)_{F,L1} \\ u(t)_{F,L2} \\ u(t)_{F,L3} \end{bmatrix} \tag{3}$$

Ein Filter 22 bestimmt dann die Werte der $\alpha\beta0$-Komponenten der Spannung aber auch des gemessenen Filterstroms $i_{F,L1}$ für eine vordefinierte Frequenz, beispielsweise der Grundschwingung oder der ersten Harmonischen der Schaltfrequenz.

Unter Berücksichtigung der festen Winkelbeziehung zwischen den Phasen L1, L2 und L3 im $\alpha\beta0$-System wird unter Berücksichtigung beispielsweise von $\Delta\varphi$ aus den gemessenen Spannungswerten ein Referenzfilterstromwert $i_{F,ref,L1}$ für die Phase L1 berechnet. Der jeweils zu berücksichtigende Phasenwinkel $\Delta\varphi$ hängt wie folgt von der jeweils gemessenen Phase für den Filterstrom oder den Differenzfilterstrom ab:

Tabelle 1:

| Messung | $i_{F,L1}$ | $i_{F,L2}$ | $i_{F,L3}$ | $i_{F,L1}$-$i_{F,L2}$ | $i_{F,L2}$-$i_{F,L3}$ | $i_{F,L3}$-$i_{F,L1}$ |
|---------|------------|------------|------------|------------------------|------------------------|------------------------|
| $\Delta\varphi$ | 0 | $\dfrac{2\pi}{3}$ | $\dfrac{-2\pi}{3}$ | $\dfrac{-\pi}{6}$ | $\dfrac{\pi}{2}$ | $\dfrac{-5\pi}{6}$ |

Der Referenzstrom $i_{F,ref,L1}$ wird beispielsweise anhand der Kennwerte für die verwendeten Bauelemente, also der bekannten Induktivitäten, Widerstände und Kapazitäten im $\alpha\beta0$-berechnet.

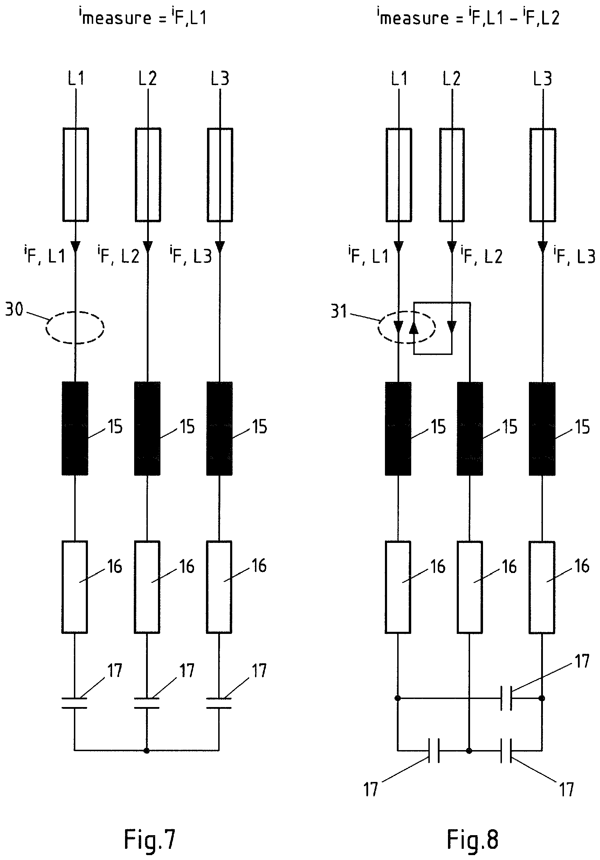

Wird beispielsweise ein Saugkreis in Sternschaltung, wie er in Fig. 7 dargestellt ist, als Filter verwendet und wird über einen Stromsensor 30, beispielsweise in Form eines induktiven Stromwandlers die Phase L1 gemessen, so ergibt sich beispielsweise bei der Berücksichtigung der Grundschwingung $\omega$ im mit Netzfrequenz drehenden $\alpha\beta$ Koordinatensystem die $\alpha\beta$-Komponenten der Filterspannung $u_F$ wie folgt aus:

$$\underline{u}_{F\alpha\beta0} = u_{F,\alpha} + j \cdot u_{F,\beta} = u_F \cdot e^{j\cdot(\omega t + \varphi_u)} = u_F \cdot \big(Cos(\omega t + \varphi_u) + j \cdot Sin(\omega t + \varphi_u)\big) \quad (4)$$

durch Multiplikation mit $e^{-j\omega t}$ zu

$$\underline{u}_F = \underline{u}_{F\alpha\beta0} \cdot e^{-j\cdot\omega t} = u_F \cdot \big(Cos(\varphi_u) + j \cdot Sin(\varphi_u)\big) \quad (4a)$$

Die Berechnung der beiden αβ-Komponenten des Referenzstroms $i_{F,ref}$ berechnet sich dann aus

$$\underline{i}_{F,ref} = i_{F,ref,\alpha} + j \cdot i_{F,ref,\beta} = \frac{\underline{u}_F}{\underline{Z}_F} \quad (5)$$

mit:

$$\underline{Z}_F = R_F(\omega) + j \cdot X_F(\omega) \quad (6)$$

Damit erhält man die beiden Komponenten für den Referenzwert des Filterstroms, welche lediglich abhängig von den bekannten Referenzwerten für die Impedanz und den jeweiligen gemessenen Filterspannungen ist:

$$\underline{i}_{F,ref,\alpha} = \frac{u_{F,\alpha} \cdot R_F(\omega) + u_{F,\beta} \cdot X_F(\omega)}{\sqrt{R_F(\omega)^2 + X_F(\omega)^2}}$$
$$\underline{i}_{F,ref,\beta} = \frac{-u_{F,\alpha} \cdot X_F(\omega) + u_{F,\beta} \cdot R_F(\omega)}{\sqrt{R_F(\omega)^2 + X_F(\omega)^2}}$$

$$(7)$$

Um den einphasigen Referenzstrom $i_{F,ref,L1}$ zu erhalten, muss der Zeiger noch auf die Achse des tatsächlich gemessenen Stroms mit dem durch die Ausführungsform der Messung gegebenen Winkel Δφ aus Tabelle 1 projiziert werden. Dies wird durch folgende Gleichung erhalten:

$$i_{F,ref,L1} = Re\big\{\underline{i}_{F,ref} \cdot e^{-j\cdot\Delta\varphi}\big\} = i_{F,ref,\alpha} \cdot Cos(\Delta\varphi) + i_{F,ref,\beta} \cdot Sin(\Delta\varphi)$$

$$(8)$$

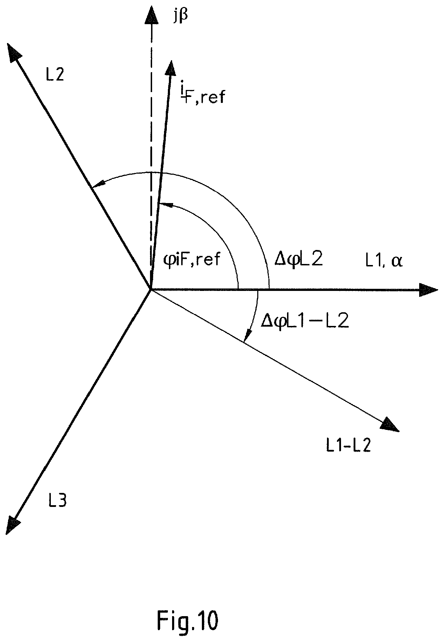

In Fig. 10 sind die zugehörigen Raumzeiger dargestellt, aus welcher sich die Projektionen bei Verwendung der einzelnen Phasen L1, L2 oder L3 insbesondere auch bei Berücksichtigung von Differenzstrommessungen ergeben und entspricht daher einer Darstellung der Differenzwinkel aus Tabelle 1 im mit Netzfrequenz drehenden αβ-Koordinatensystem.

Es kann gemäß einem weiteren Ausführungsbeispiel, wie in Fig. 8 dargestellt, unter Verwendung eines Stromsensors 31 auch eine Filterstromdifferenz, beispielsweise eine Filterstromdifferenz zwischen den Phasen L1 und L2 gemessen werden. In diesem Fall ist für die Berechnung des Referenzstromes ein anderer Differenzwinkel Δφ heranzuziehen. Wie man der Tabelle entnehmen kann, ist dann ein Winkel von - π/6 zu verwenden.

In dem in Fig. 6 dargestellten Vergleichsmittel 25 kann dann beispielsweise die Differenz zwischen gemessenem Phasenstrom $i_{F,L1}$, dem Istwert 28, im Filter mit dem Referenzfilterstrom $i_{F,ref,L1}$ der Phase L1, also dem Sollwert 27, ermittelt werden. Bevorzugt wird hier ein zeitlicher Mittelwert der Differenz gebildet, um mögliche Messunsicherheiten und Messschwankungen, d.h. Messfehler zu minimieren. Der Mittelwert der Differenz ergibt sich aus

$$\Delta i_{F,L1,MW}(t) = \frac{1}{T}\int_t^{t+T}(i_{F,ref,L1}(\tau) - i_{F,L1}(\tau))d\tau \quad (9)$$

Der zeitliche Mittelwert des Sollwertes ergibt sich aus

$$i_{F,ref,L1,MW}(t) = \frac{1}{T}\int_t^{t+T} i_{F,ref,L1}(\tau)\,d\tau \quad (10)$$

Über die Vergleichsmittel 25 kann dann mittels eines Fehlerkriteriums, ein Fehlerinformationssignal S erzeugt werden, wenn folgende Gleichung erfüllt ist:

$$\Delta i_{F,L1,MW}(t) > i_{F,ref,L1,MW}(t) \cdot limit_{F,rel} \qquad (11)$$

$limit_{F,rel}$ ist das Fehlerkriterium und ein vorbestimmter Wert, der beispielsweise für die Überwachung eines Filterdefekts zwischen 10 % und 15 % beträgt und die Breite der erlaubten Abweichungen relativ zum Referenzfilterstrom vorgibt. Dieser Wert kann frei gewählt werden. Das Fehlerinformationssignal S kann dann weiter ausgewertet werden. Je nach zu überwachender Eigenschaft des Filters, also z.B. Aufbau, Alterung oder Defekt, können verschiedene Fehlerkriterien gewählt werden, deren Werte an den entsprechenden Anwendungsfall angepasst sind.

In Fig. 6 sind darüber hinaus noch zwei weitere Ausführungsformen dargestellt, bei welchen zwei Phasen, beispielsweise die Phasen L1 und L2 oder auch alle drei Phasen L1, L2, L3 unter Verwendung von Stromsensoren gemessen werden.

Bei der Messung von zwei Stromphasen L1 und L2 können diese über folgende Transformation 21 in ein aß-System transformiert werden:

$$\begin{bmatrix} i(t)_{F,\alpha} \\ i(t)_{F,\beta} \end{bmatrix} = \begin{bmatrix} 1 & 0 \\ \frac{1}{\sqrt{3}} & \frac{2}{\sqrt{3}} \end{bmatrix} \cdot \begin{bmatrix} i(t)_{F,L1} \\ i(t)_{F,L2} \end{bmatrix} \qquad (12)$$

Bei der Messung aller drei Filterstromphasen ergibt sich die Transformation 20 der Filterströme in das $\alpha\beta0$-System aus Gleichung (1).

$$\begin{bmatrix} i(t)_{F,\alpha} \\ i(t)_{F,\beta} \\ i(t)_{F,0} \end{bmatrix} = \frac{1}{3} \cdot \begin{bmatrix} 2 & -1 & -1 \\ 0 & \sqrt{3} & -\sqrt{3} \\ 1 & 1 & 1 \end{bmatrix} \cdot \begin{bmatrix} i(t)_{F,L1} \\ i(t)_{F,L2} \\ i(t)_{F,L3} \end{bmatrix} \qquad (13)$$

Nach einem Filter 22 auf die zu betrachtende Frequenz können im $\alpha\beta0$- oder $\alpha\beta$-Koordinatensystem die Komponenten gemäß Schritt 23' oder 23"der Referenzfilterströme berechnet und mit den $\alpha\beta$-Komponenten oder $\alpha\beta0$-Komponenten der gemessenen Filterströme zur Bestimmung eines Fehlerkriteriums verglichen werden.

Fig. 7 und Fig. 8 zeigen Ausführungsbeispiele von Filterstrommessungen bzw. Differenzfilterstrommessungen. In Fig. 7 ist an der Phase L1 ein Stromsensor 30, beispielsweise ein Rogowski-Stromwandler oder ein Stromwandler mit einem Hall-Sensor angeordnet, welcher den durch den Stromfluss erzeugten magnetischen Fluss zur Bestimmung des Stromflusses misst. Diese Stromwandler 30 zeigen eine gute Genauigkeit und ein robustes Messverhalten und können in ihrem Messbereich genau an die Filterströme angepasst werden, so dass eine optimale Messwertauflösung erzielt werden kann. Wie in Fig. 8 zu erkennen ist, kann mit einem einzigen Stromsensor 31 auch direkt ein Differenzstrom durch gegenläufige Anordnung der Phasen L1 und L2 in dem Stromsensor 31 gemessen werden.

Durch die Messung der Filterströme auch in nur einer Phase des Filters ist es möglich Impedanzänderung des Filters frühzeitig zu erkennen. Die Tabelle 2 zeigt die unterschiedlichen Fehlerarten, welche bei einphasiger, zweiphasiger oder dreiphasiger Messung der Filterströme detektiert werden können.

Wie zu erkennen ist, kann selbst mit einer einphasigen Filterstrommessung, also mit besonders geringem Messaufwand, bei einer Sternschaltung der Filter sowohl ein Zuleitungsbruch als auch das Abweichen vom Nennwert einer Komponente des Filters detektiert werden. Bei einem Filter in Dreiecksschaltung muss hierzu die Messung eines Differenzphasenstroms $\Delta i$ erfolgen. In der Tabelle 2 bedeuten n/a = nicht zutreffend, x = Erkennung ist möglich, --- = Erkennung ist nicht möglich, I = einphasige Strommessung, $\Delta i$ = Differenzstrommessung zweier Phasen

Tabelle 2

| Messung | 3-phasig | | | 2-phasig | | | 1-phasig | | |
|---|---|---|---|---|---|---|---|---|---|
| Fehlerart | Stern | Stern-N | Dreieck | Stern | Stern-N | Dreieck | Stern | Stern-N | Dreieck |
| N offen | n/a | x | n/a | n/a | --- | n/a | n/a | --- | n/a |
| Zuleitung unterbrochen | x | x | x | x | x | x | x | x | x |
| Abweichung vom Komponentennennwert | x | x | x | x | x | x | i | i | $\Delta i$ |

Die Überwachung der Filterströme ist insbesondere vorteilhaft bei Vorrichtungen zur Abgabe elektrischer Leistungen, welche nur schwer zugänglich sind, beispielsweise Offshore-Anlagen, da die Filterüberwachung elektronisch erfolgt und auch Alterungsprozesse, besonders wichtig bei Kondensatoren, im Vorfeld erkennt. Darüber hinaus ergeben sich insbesondere Vorteile dadurch, dass der Weiterbetrieb der Anlagen durch Abschalten einzelner Filtergruppen unter Verwendung entsprechender Mittel zur Trennung der Filtergruppen ermöglicht wird.

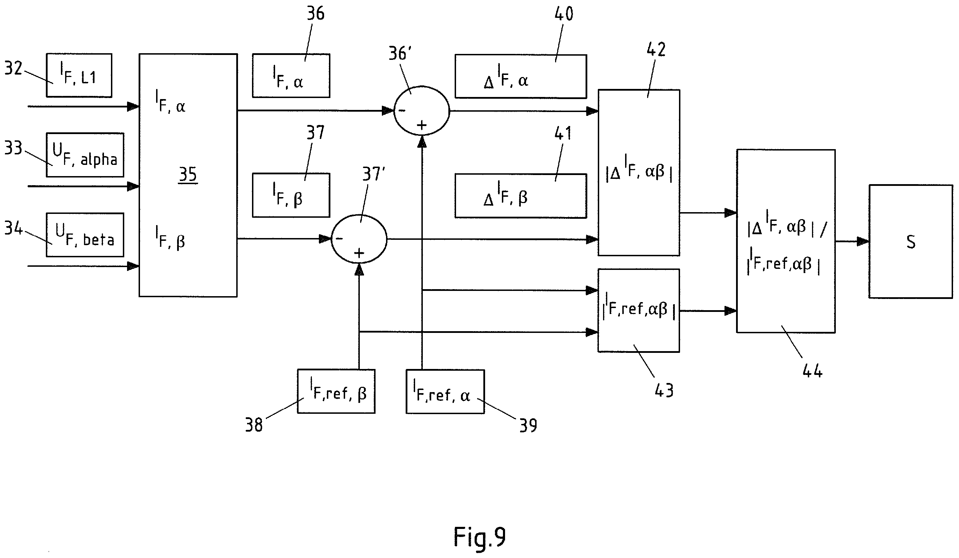

Anhand von Fig. 9 soll ein weiteres Ausführungsbeispiel angegeben werden, bei welchem ein direkter Vergleich zwischen den $\alpha\beta$-Komponenten des in einer Phase gemessenen Filterstroms $I_{F,L1}$ durchgeführt wird.

Hierzu wird zunächst in Schritt 32 der in der Phase L1 gemessene Filterstrom unter Berücksichtigung der zur Verfügung stehenden Spannungswerte 33 und 34 $U_{f,alpha}$ und $u_{f,beta}$ im $\alpha\beta0$-Koordinatensystem die Komponenten des gemessenen Filterstroms $i_F$ im mit Netzfrequenz rotierenden $\alpha\beta$-System in Schritt 35 berechnet. Anschließend erfolgt eine Differenzbildung der jeweiligen $\alpha\beta$-Komponenten 36, 37 der gemessenen Filterströme im Schritt 36', 37' mit den Referenzwerten des Filterstroms der $\alpha\beta$-Komponenten 38, 39. Von dem die Differenzwerte 40, 41 im $\alpha\beta$-Koordinatensystem aufweisenden Differenzvektor wird gemäß Schritt 42 der Betrag gebildet und einem Vergleichsschritt 44 zugeführt. Im Vergleichsschritt 44 wird der Betrag des Differenzvektors im aß-System mit dem Betrag des Filterstroms Referenzvektors $I_{F,ref,\alpha\beta}$ verglichen und beispielsweise ein Quotient gebildet und mit einem Fehlerkriterium in p.u. verglichen. Hieraus kann dann ein Fehlerinformationssignal S erzeugt werden.

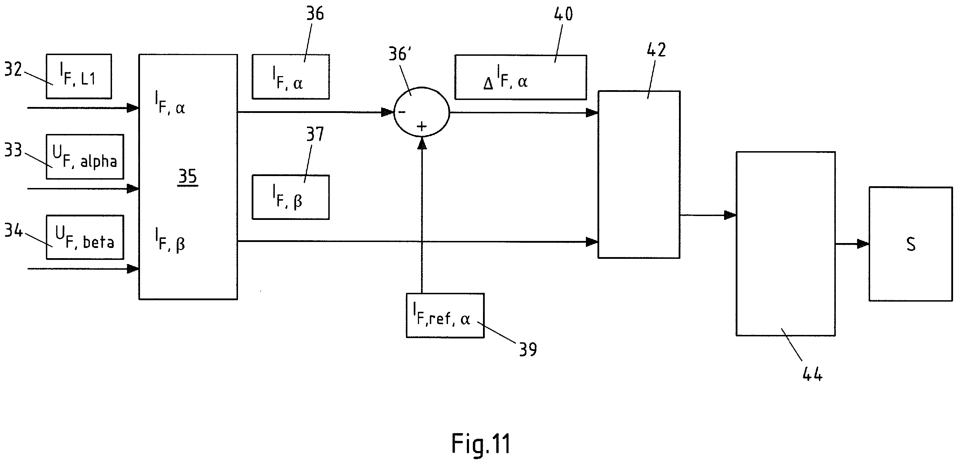

Ein weiteres Ausführungsbeispiel ist in Fig. 11 dargestellt, welches eine Vereinfachung des Ausführungsbeispiels aus Fig. 9 darstellt. Unter der Annahme, dass die Spannungskomponente in der $\beta$-Achse und die Filterstromkomponente in der $\alpha$-Achse liegt, kann das erfindungsgemäße Verfahren insofern vereinfacht werden, als dass eine Differenzbildung nur in einer der $\alpha\beta$ -Komponenten 36, 37 durchgeführt werden muss. Dies ist beispielsweise für ein kapazitives Filter mit hinreichender Genauigkeit der Fall.

Analog zur Fig. 9 werden in Fig. 11 zunächst in Schritt 35 aus dem in der Phase L1 gemessenen Filterstrom 32 unter Berücksichtigung der zur Verfügung stehenden Spannungswerte $U_{F,alpha}$, 33 und $U_{F,beta}$, 34 im $\alpha\beta0$-Koordinatensystem die Komponenten des gemessenen Filterstroms $I_{F,\alpha}$, 36 und $I_{F,\beta}$, 37 im mit Netzfrequenz rotierenden aß-Koordinatensystem berechnet. Anschließend erfolgt eine Differenzbildung nur der $\alpha$-Komponente 36 mit dem Referenzwert der $\alpha$-Komponente des Filterstroms 39 zum Differenzwert 40. Im Schritt 42 wird aus der $\alpha$-Komponente 40 und der $\beta$-Komponente 37 der Betragsvektor gebildet. Dieser Wert kann dann im Vergleichsschritt 44 mit einem vorgebbaren Fehlerkriterium verglichen werden. Dieses kann beispielsweise unter Berücksichtigung des Sollwertes der $\alpha$-Komponente des Filterstroms 39 gebildet werden. Aus dem Vergleich kann dann ein Fehlerinformationssignal S erzeugt werden und beispielsweise eine Änderung des Betriebszustands der Vorrichtung zur Abgabe elektrischer Energie bewirken. Analog zur $\alpha$-Komponente 36 ist auch denkbar die entsprechende $\beta$-Komponente 37 für den Vergleich mit der Referenzgröße zu verwenden, sofern die Voraussetzung, dass die Komponente des Filterstroms in dieser Achse liegt, gegeben ist.

**Patentansprüche**

1. Vorrichtung zur Abgabe regenerativ erzeugter elektrischer Leistung an eine Verbraucherimpedanz (3), welche mindestens einen Umrichter (5, 6, 11, 12) und mindestens einen Filter (7, 8, 9, 14) aufweist, wobei die Vorrichtung zur Abgabe elektrischer Leistung dreiphasig ausgebildet ist und der mindestens eine Filter entweder in einer Sternschaltung oder einer Dreieckschaltung parallel zu Leistungsausgängen der Vorrichtung betrieben wird, wobei Mittel (7', 8',9',14') zur Bestimmung von mindestens einem Filterstrom des mindestens einen dreiphasigen Filters (7, 8, 9, 14) vorgesehen sind, welche derart ausgebildet sind, dass diese eine Bestimmung des mindestens einen Filterstroms während des Betriebs der Vorrichtung ermöglichen, wobei Vergleichsmittel (25) vorgesehen sind, welche unter Verwendung eines Sollwertes (27) und Istwertes (28) des Filterstroms sowie eines vorgebbaren Fehlerkriteriums ein Fehlerinformationssignal (S) erzeugen, wobei unter Verwendung von Spannungswerten der drei Phasen des Filters der Sollwert (27) des Filterstroms ermittelt wird, wobei als Mittel (7', 8',9',14') zur Bestimmung des mindestens einen Filterstroms des mindestens einen dreiphasigen Filters (7, 8, 9, 14) lediglich ein Stromsensor (30) zur Messung des Stroms in lediglich einer Phase des mindestens einen dreiphasigen Filters (7, 8, 9, 14) oder mindestens ein Stromsensor (31) zur Messung des Stroms in lediglich zwei Phasen des mindestens einen dreiphasigen Filters (7, 8, 9, 14) vorgesehen ist.

2. Vorrichtung nach Anspruch 1,
   **dadurch gekennzeichnet, dass**
   mindestens ein Stromsensor (31) vorgesehen ist, welcher zur Messung des Differenzfilterstroms zweier Phasen des mindestens einen dreiphasigen Filters (7, 8, 9, 14) ausgebildet ist.

3. Vorrichtung nach Anspruch 1 oder 2,

**dadurch gekennzeichnet, dass**
mindestens eine Filtergruppe(7, 8, 9) vorgesehen ist und die Mittel (7', 8',9') zur Bestimmung des mindestens einen Filterstroms zumindest teilweise zur Bestimmung der Filterströme oder Differenzfilterströme der einzelnen Filtergruppen (7, 8, 9) ausgebildet sind.

4. Vorrichtung nach einem der Ansprüche 1 bis 3,
**dadurch gekennzeichnet, dass**
die Vorrichtung zur Abgabe elektrischer Leistung einen Netzanschluss (3) aufweist und mindestens ein Netzfilter (9, 14) vorgesehen ist.

5. Vorrichtung nach einem der Ansprüche 1 bis 4,
**dadurch gekennzeichnet, dass**
die Vorrichtung zur Abgabe elektrischer Leistung eine Windenergieanlage mit einer doppeltgespeisten Asynchronmaschine oder eine Windenergieanlage mit einer Synchronmaschine ist.

6. Vorrichtung nach einem der Ansprüche 1 bis 5,
**dadurch gekennzeichnet, dass**
der mindestens eine Filter als Saugkreis, Hochpass-, Tiefpass-, RC-Filter oder als Filter höherer Ordnung ausgebildet ist.

7. Vorrichtung nach Anspruch 1 bis 6,
**dadurch gekennzeichnet, dass**
Mittel zur Betriebsänderung der Vorrichtung, Mittel zur Abschaltung mindestens eines Filters oder einer Filtergruppe oder Mittel zur Änderung der Schaltfrequenz des Umrichters abhängig vom Fehlerinformationssignal vorgesehen sind.

8. Verfahren zum Betreiben einer Vorrichtung zur Abgabe regenerativ erzeugter elektrischer Leistung an eine Verbraucherimpedanz, nach einem der Ansprüche 1 bis 7, wobei die Vorrichtung mindestens einen Umrichter und mindestens einen dreiphasigen Filter aufweist,
**dadurch gekennzeichnet, dass**
während des Betriebs der Vorrichtung zur Abgabe elektrischer Leistung mindestens ein Filterstrom in dem mindestens einen Filter ermittelt und der mindestens eine Filter abhängig vom ermittelten Filterstrom überwacht wird, wobei Vergleichsmittel vorgesehen sind, welche unter Verwendung des Sollwertes und Istwertes des Filterstroms sowie eines vorgebbaren Fehlerkriteriums ein Fehlerinformationssignal erzeugen, wobei unter Verwendung der Spannungswerte der drei Phasen des Filters der Sollwert des Filterstroms ermittelt wird.

9. Verfahren nach Anspruch 8,
**dadurch gekennzeichnet, dass**
unter Verwendung mindestens eines Stromsensors der Filterstrom in mindestens einer Phase des mindestens einen dreiphasigen Filters oder ein Differenzfilterstrom zweier Phasen des mindestens einen dreiphasigen Filters gemessen wird.

10. Verfahren nach Anspruch 8 oder 9,
**dadurch gekennzeichnet, dass**
Vergleichsmittel unter Verwendung des mindestens einen Filterstroms mindestens einer Phase des mindestens einen dreiphasigen Filters oder mindestens eines Differenzfilterstroms zweier Phasen mindestens eines dreiphasigen Filters und der gemessenen Spannungswerte an dem mindestens einen dreiphasigen Filter sowie eines vorgebbaren Fehlerkriteriums ein Fehlerinformationssignal erzeugen.

11. Verfahren nach einem der Ansprüche 8 bis 10,
**dadurch gekennzeichnet, dass**
der Filterstrom jeweils in mindestens einer Phase oder jeweils der Differenzfilterstrom zweier Phasen mindestens einer Filtergruppe gemessen wird und zumindest teilweise die einzelnen Filtergruppen abhängig von den ermittelten Filterströmen oder Differenzfilterströmen überwacht werden.

12. Verfahren nach einem der Ansprüche 8 bis 11,
**dadurch gekennzeichnet, dass**
das Fehlerinformationssignal aus einem Vergleich zwischen Soll- und Istwert mindestens eines Filterstroms oder aus einem Vergleich des Soll- und Istwerts mindestens einer unter Verwendung des ermittelten Filterstroms berechneten Größe sowie mindestens eines vorgebbaren Fehlerkriteriums berechnet wird.

**13.** Verfahren nach einem der Ansprüche 8 bis 12,
**dadurch gekennzeichnet, dass**
das mindestens eine vorgebbare Fehlerkriterium in Abhängigkeit der zu überwachenden Eigenschaft des mindestens einen Filters gewählt wird.

**14.** Verfahren nach einem der Ansprüche 8 bis 13,
**dadurch gekennzeichnet, dass**
die Ermittlung des mindestens einen Filterstroms oder des mindestens einen Differenzfilterstroms für vordefinierte Frequenzen, insbesondere für die Grundschwingung oder eine Harmonische, durchgeführt wird.

**15.** Verfahren nach einem der Ansprüche 8 bis 14,
**dadurch gekennzeichnet, dass**
abhängig von dem Fehlerinformationssignal der Betrieb der Vorrichtung geändert wird, mindestens ein Filter abgeschaltet und/oder die Schaltfrequenz des Umrichters geändert wird.

**16.** Computerprogrammprodukt, umfassend Befehle, die bewirken, dass die Vorrichtung nach einem der Ansprüche 1 bis 7 die Verfahrensschritte nach einem der Ansprüche 8 bis 15 ausführt.

**Claims**

**1.** An apparatus for delivering regeneratively produced electrical power to a load impedance (3), having at least one converter (5, 6, 11, 12) and at least one filter (7, 8, 9, 14), wherein the apparatus for delivering electrical power is of three-phase design and the at least one filter is operated either in a star circuit or a delta circuit parallel to power outputs of the apparatus,
wherein
means (7', 8',9',14') for determining at least one filter current of the at least one three-phase filter (7, 8, 9, 14) are provided, which are designed to enable a determination of the at least one filter current during operation of the apparatus, wherein comparison means (25) are provided, which generate an error information signal (S) using a desired value (27) and actual value (28) of the filter current and a predefinable error criterion, wherein the desired value (27) of the filter current is determined using voltage values of the three phases of the filter, wherein only a current sensor (30) for measuring the current in only one phase of the at least on three-phase filter (7, 8, 9, 14) or at least one current sensor (31) for measuring the current in only two phases of the at least one three-phase filter (7, 8, 9, 14) are provided as means (7', 8', 9', 14') for determining the at least one filter current of the at least one three-phase filter (7, 8, 9, 14).

**2.** The apparatus according to Claim 1,
**characterised in that**
at least one current sensor (31) is provided, which is designed to measure the differential filter current of two phases of the at least one three-phase filter (7, 8, 9,14).

**3.** The apparatus according to Claims 1 or 2,
**characterised in that**
at least one filter group (7, 8, 9) is provided and the means (7', 8', 9') for determining the at least one filter current are at least partially designed to determine the filter currents or differential filter currents of the individual filter groups (7, 8, 9).

**4.** The apparatus according to any one of Claims 1 to 3,
**characterised in that**
the apparatus for delivering electrical power has a mains connection (3) and at least one mains filter (9, 14) is provided.

**5.** The apparatus according to any one of Claims 1 to 4,
**characterised in that**
the apparatus for delivering electrical power is a wind turbine with a double-fed asynchronous generator or a wind turbine with a synchronous generator.

**6.** The apparatus according to any one of Claims 1 to 5,
**characterised in that**
the at least one filter is designed as an absorption circuit, high-pass, low-pass or RC filter or as a higher-order filter.

**7.** The apparatus according to Claims 1 to 6,
**characterised in that**
means for changing the operation of the apparatus, means for deactivating at least one filter or a filter group, or means for changing the switching frequency dependent on the error information signal, are provided.

**8.** A method for operating an apparatus for delivering regeneratively produced electrical power to a load impedance, according to any one of Claims 1 to 7, wherein the apparatus has at least one converter and at least one three-phase filter,
**characterised in that**
during operation of the apparatus for delivering electrical power, at least one filter current is determined in the least one filter and the at least one filter is monitored dependent on the determined filter current, wherein comparison means are provided, which generate an error information signal using the desired value and actual value of the filter current and a predefinable error criterion, wherein the desired value of the filter current is determined using the voltage values of the three phases of the filter.

**9.** The method according to Claim 8,
**characterised in that**
the filter current in at least one phase of the at least one three-phase filter or a differential filter current of two phases of the at least one three-phase filter is measured using at least one current sensor.

**10.** The method according to Claim 8 or 9,
**characterised in that**
comparison means generate an error information signal using the at least one filter current of at least one phase of at least one three-phase filter or at least one differential filter current of two phases of at least one three-phase filter and the measured voltage values at the at least one three-phase filter as well as a predefinable error criterion.

**11.** The method according to any one of Claims 8 to 10,
**characterised in that**
in each case the filter current in at least one phase or in each case the differential filter current of two phases of at least one filter group is measured and at least to some extent the individual filter groups are monitored dependent on the determined filter currents or differential filter currents.

**12.** The method according to any one of Claims 8 to 11,
**characterised in that**
the error information signal is calculated from a comparison between the desired and actual values of at least one filter current or from a comparison of the desired and actual values of at least one variable, which is calculated using the determined filter current, as well as at least one predefinable error criterion.

**13.** The method according to any one of Claims 8 to 12,
**characterised in that**
the at least one predefinable error criterion is selected dependent on the characteristic to be monitored of the least one filter.

**14.** The method according to any one of Claims 8 to 13,
**characterised in that**
the determination of the at least one filter current or of the at least one differential filter current is carried out for predefined frequencies, in particular for the fundamental oscillation or a harmonic.

**15.** The method according to any one of Claims 8 to 14,
**characterised in that**
dependent on the error information signal, the operation of the apparatus is changed, at least one filter is deactivated, and/or the switching frequency of the converter is changed.

**16.** A computer program product comprising instructions which cause an apparatus according to any one of Claims 1 to 7 to carry out the method steps according to any one of claims 8 to 15.

**Revendications**

1. Dispositif pour fournir de l'énergie électrique produite à partir de sources renouvelables à une impédance de consommateur (3), lequel dispositif comporte au moins un convertisseur (5, 6, 11, 12) et au moins un filtre (7, 8, 9, 14), le dispositif pour fournir de l'énergie électrique étant de conception triphasée et l'au moins un filtre fonctionnant soit dans un circuit en étoile, soit dans un circuit en triangle, en parallèle avec les sorties de puissance du dispositif, dans lequel

   des moyens (7', 8', 9', 14') pour déterminer au moins un courant de filtre de l'au moins un filtre triphasé (7, 8, 9, 14) sont prévus, lesquels moyens sont conçus de telle sorte qu'ils permettent de déterminer l'au moins un courant de filtre pendant le fonctionnement du dispositif, des moyens de comparaison (25) étant prévus qui génèrent un signal d'information d'erreur (S) en utilisant une valeur de consigne (27) et une valeur réelle (28) du courant de filtre ainsi qu'un critère d'erreur prédéterminable, la valeur de consigne (27) du courant de filtre étant déterminée en utilisant des valeurs de tension des trois phases du filtre, un seul capteur de courant (30) pour mesurer le courant dans seulement une phase de l'au moins un filtre triphasé (7, 8, 9, 14) ou au moins un capteur de courant (31) pour mesurer le courant dans seulement deux phases de l'au moins un filtre triphasé (7, 8, 9, 14) étant prévu comme moyen (7', 8', 9', 14') pour déterminer l'au moins un courant de filtre de l'au moins un filtre triphasé (7, 8, 9, 14).

2. Dispositif selon la revendication 1,
   **caractérisé en ce qu'**
   il est prévu au moins un capteur de courant (31) qui est conçu pour mesurer le courant de filtre différentiel de deux phases de l'au moins un filtre triphasé (7, 8, 9, 14).

3. Dispositif selon la revendication 1 ou 2,
   **caractérisé en ce qu'**
   au moins un groupe de filtres (7, 8, 9) est prévu et les moyens (7', 8', 9') pour déterminer l'au moins un courant de filtre sont au moins partiellement conçus pour déterminer les courants de filtre ou les courants de filtre différentiels des groupes de filtres individuels (7, 8, 9).

4. Dispositif selon l'une des revendications 1 à 3,
   **caractérisé en ce que**
   le dispositif pour fournir de l'énergie électrique présente une connexion réseau (3) et au moins un filtre réseau (9, 14) est prévu.

5. Dispositif selon l'une des revendications 1 à 4,
   **caractérisé en ce que**
   le dispositif pour fournir de l'énergie électrique est une éolienne avec une machine asynchrone à double alimentation ou une éolienne avec une machine synchrone.

6. Dispositif selon l'une des revendications 1 à 5,
   **caractérisé en ce que**
   l'au moins un filtre est conçu comme un circuit résonant série, un filtre passe-haut, un filtre passe-bas, un filtre RC ou un filtre d'ordre supérieur.

7. Dispositif selon les revendications 1 à 6,
   **caractérisé en ce que**
   des moyens pour modifier le fonctionnement du dispositif, des moyens pour désactiver au moins un filtre ou un groupe de filtres ou des moyens pour modifier la fréquence de commutation du convertisseur en fonction du signal d'information d'erreur sont prévus.

8. Un procédé pour le fonctionnement d'un dispositif pour fournir de l'énergie électrique produite à partir de sources renouvelables à une impédance de consommateur, selon l'une des revendications 1 à 7, dans lequel le dispositif comporte au moins un convertisseur et au moins un filtre triphasé,
   **caractérisé en ce que**
   pendant le fonctionnement du dispositif pour fournir de l'énergie électrique, au moins un courant de filtre est déterminé dans l'au moins un filtre et l'au moins un filtre est surveillé en fonction du courant de filtre déterminé, des moyens de comparaison étant prévus qui génèrent un signal d'information d'erreur en utilisant la valeur de consigne et la valeur réelle du courant de filtre ainsi qu'un critère d'erreur prédéterminable, la valeur de consigne du courant de filtre étant déterminée en utilisant les valeurs de tension des trois phases du filtre.

9. Procédé selon la revendication 8,
**caractérisé en ce qu'**
en utilisant au moins un capteur de courant, le courant de filtre dans au moins une phase de l'au moins un filtre triphasé ou un courant de filtre différentiel de deux phases de l'au moins un filtre triphasé est mesuré.

10. Procédé selon la revendication 8 ou 9,
**caractérisé en ce que**
les moyens de comparaison génèrent un signal d'information d'erreur en utilisant l'au moins un courant de filtre d'au moins une phase de l'au moins un filtre triphasé ou au moins un courant de filtre différentiel de deux phases d'au moins un filtre triphasé et les valeurs de tension mesurées à l'au moins un filtre triphasé ainsi qu'un critère d'erreur prédéterminable.

11. Procédé selon l'une des revendications 8 à 10,
**caractérisé en ce que**
dans chaque cas le courant de filtre dans au moins une phase ou dans chaque cas le courant de filtre différentiel de deux phases d'au moins un groupe de filtres est mesuré, et les groupes de filtres individuels sont au moins partiellement surveillés en fonction des courants de filtre ou des courants de filtre différentiels déterminés.

12. Procédé selon l'une des revendications 8 à 11,
**caractérisé en ce que**
le signal d'information d'erreur est calculé à partir d'une comparaison entre la valeur de consigne et la valeur réelle d'au moins un courant de filtre ou à partir d'une comparaison entre la valeur de consigne et la valeur réelle d'au moins une variable calculée en utilisant le courant de filtre déterminé ainsi qu'au moins un critère d'erreur prédéterminable.

13. Procédé selon l'une des revendications 8 à 12,
**caractérisé en ce que**
l' au moins un critère d'erreur prédéterminable est sélectionné en fonction de la propriété à surveiller de l'au moins un filtre.

14. Procédé selon l'une des revendications 8 à 13,
**caractérisé en ce que**
la détermination de l'au moins un courant de filtre ou de l'au moins un courant de filtre différentiel est effectuée pour des fréquences prédéfinies, en particulier pour la fondamentale ou une harmonique.

15. Procédé selon l'une des revendications 8 à 14,
**caractérisé en ce qu'**
en fonction du signal d'information d'erreur, le fonctionnement du dispositif est modifié, au moins un filtre est désactivé et/ou la fréquence de commutation du convertisseur est modifiée.

16. Produit de programme informatique comprenant des instructions qui ont pour effet que le dispositif selon l'une des revendications 1 à 7 réalise les étapes du procédé selon l'une des revendications 8 à 15.

Fig.1

Fig.2

Fig.3

Fig.4

Fig.5

Fig.6

$i_{measure} = {}^iF_{,L1}$

$i_{measure} = {}^iF_{,L1} - {}^iF_{,L2}$

L1  L2  L3

$^iF, L1$  $^iF, L2$  $^iF, L3$

30

15  15  15

16  16  16

17  17  17

L1  L2  L3

$^iF, L1$  $^iF, L2$  $^iF, L3$

31

15  15  15

16  16  16

17  17  17  17

Fig.7          Fig.8

Fig.9

Fig.10

Fig.11

EP 3 254 351 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8898025 B2
- EP 2833535 A1
- US 20110057517 A1
- EP 2814150 A2
- US 20010048604 A1
- JP 2012143094 A
- EP 0645866 A1